# FASCICULE DE BREVET EUROPEEN

(11) **EP 2 478 134 B1**
(45) Date de publication et mention de la délivrance du brevet: **11.09.2013**
(21) Numéro de dépôt: 10760286.4
(22) Date de dépôt: 14.09.2010
(51) Int. Cl.: C30B 1/12, C30B 29/06, H01L 31/0392, H01L 21/02, H01L 31/18

(54) **PROCÉDÉ DE CRISTALLISATION D'UNE COUCHE**
VERFAHREN ZU KRISTALLISIERUNG EINER SCHICHT
PROCESS FOR THE CRYSTALLIZATION OF A LAYER

(30) Priorité: 14.09.2009 FR 0956301
(43) Date de publication de la demande: 25.07.2012
(73) Titulaire: Commissariat à l'Énergie Atomique et aux Énergies Alternatives, 75015 Paris (FR)
(72) Inventeur: CAYRON, Cyril, F-38100 Grenoble (FR)
(74) Mandataire: Ilgart, Jean-Christophe
(86) Numéro de dépôt international: PCT/EP2010/063456
(87) Numéro de publication internationale: WO 2011/029952

(56) Documents cités:
- US-A1- 2005 188 917
- BERGMANN ET AL.: "The future of crystalline silicon films on foreign substrates", THIN SOLID FILMS, vol. 403-404, 2002, pages 162-169, XP002566392, cité dans la demande
- TUZUN O ET AL: "N-type polycrystalline silicon films formed on alumina by aluminium induced crystallization and overdoping", THIN SOLID FILMS, ELSEVIER-SEQUOIA S.A. LAUSANNE, CH, vol. 516, no. 20, 30 août 2008 (2008-08-30), pages 6892-6895, XP022777877, ISSN: 0040-6090 [extrait le 2007-12-17]

## Description

L'invention ressortit à un procédé de cristallisation d'une couche. Elle peut notamment concerner les couches minces en silicium rencontrées dans les capteurs d'énergie solaire et les circuits de micro-électronique.

La structure cristalline de la couche n'est pas indifférente pour ces applications: les joints de grains ont en général une influence néfaste en absorbant les porteurs de charges électriques et en diminuant donc l'efficacité du dispositif. On cherche en général à obtenir des structures cristallines à gros grains voire monocristallines, ce qui est impossible de façon directe avec des procédés de fabrication usuels où les couches sont déposées, alors que d'autres procédés, caractérisés par le découpage des couches dans des blocs cristallins ayant la structure cristalline souhaitée, sont souvent trop coûteux pour être considérés.

Il est toutefois connu que des cristallisations de la couche accompagnées d'un grossissement des grains peuvent être provoquées par une élévation de température permettant de recuire le cristal. Ces cristallisations sont souvent associées à l'application sur la couche d'un germe cristallin ayant la structure cristalline qu'on veut lui attribuer, et qu'il impose peu à peu à la couche à mesure que le traitement thermique se prolonge. Dans le cas d'une couche de silicium amorphe ou faiblement cristallisée à l'origine, on a proposé des cristallisations induites par l'aluminium entre 200°C et 400°C, des cristallisations en phase solide entre 550°C et 800 °C, des recuits thermiques rapides sous lampe entre 700°C et 1200°C, des cristallisations par laser entre 1200°C 1500°C et des cristallisations par fusion de zone entre 1200°C et 1500°C, tous ces procédés étant réalisés sans transfert de structure d'un germe cristallin. Des techniques de transfert de structure d'un germe cristallin sont décrites dans « Future of cristalline silicon films on foreign substrates », par Bergmann et Werner, paru dans Thin Solid films 403-404 (2002), pages 162 à 169 ; et d'autres - analogues - dans l'article de Tüzün et autres « B-type polycristalline silicon films formed on aluminium by aluminium induced crystallisation and overdoping », Thin solid Films, Elsevier - Sequoia SA, Lausanne, vol.516, n°20, 30 août 2008, pages 6892-6895. Le germe forme généralement une couche entière, sur laquelle la couche à cristalliser est appliquée ou fabriquée par dépôt, et on cherche en général à le séparer de la couche cristallisée après le traitement thermique, pour le remployer avec une autre couche à cristalliser ou parce qu'il ne conviendrait pas dans le produit fini; mais les procédés mécaniques usuels sont difficiles à mettre en oeuvre pour séparer proprement le germe de la couche, sans destruction à leur jonction. L'objet de l'invention est de proposer un procédé de cristallisation d'une couche par transfert de structure cristalline qui permette au contraire une bonne séparation de la couche et du germe cristallin, qu'on peut remployer ensuite pour d'autres couches à cristalliser, ce qui améliore la fabrication d'une série et réduit les temps et les coûts.

De plus, US-A-2005/188 917 décrit un procédé de cristallisation d'une plaque par application d'un cristal sur sa surface, sans utiliser ensuite de moyen à cales pour la décoller.

Sous une forme générale, l'invention concerne ainsi un procédé de cristallisation d'une couche, comprenant une application sur la couche d'un cristal formé d'une même matière que la couche et ayant une structure cristalline voulue pour la couche, et un traitement thermique de la couche afin d'y instaurer la structure du cristal, caractérisé en ce que l'application est produite par une pression mécanique sur la couche ou un substrat de la couche, après avoir intercalé des cales à des bords de la couche entre la couche et le cristal, produisant ainsi une flexion de la couche.

L'application de la pression de la couche sur le cristal établit une liaison intime entre eux, analogue à un soudage ou à un collage ; mais quand la pression est relâchée, les contraintes de flexion dues aux cales tendent à séparer la couche du cristal et produisent une fissuration à leur jonction.

Une couche de séparation est très avantageusement intercalée entre la couche à cristalliser et le cristal. Elle est beaucoup plus fine que la couche à cristalliser et plus fine que les cales, et elle s'étend dans une région entourée par les cales, où la couche à cristalliser est véritablement appliquée sur le cristal. Elle constitue une région fragile de l'assemblage, qui favorise la fissuration quand la pression a été relâchée. Cela est obtenu facilement si la couche de séparation est discontinue, ou si elle est d'une matière différente de celle du cristal et de la couche, ou les deux.

L'invention sera maintenant décrite plus en détail en liaison aux figures:
- la figure 1 représente l'assemblage avant l'application de la pression,
- la figure 2, l'assemblage pendant l'application de la pression,
- et la figure 3, l'assemblage quand la pression est relâchée.

Une couche 1 à cristalliser est placée au-dessus d'un cristal 3 qui doit lui imposer sa structure cristalline. La couche 1 est mince et a été déposée sur un substrat 2 qui assure sa tenue ; son épaisseur peut, à titre d'exemple, être de 100 nm environ ou de 2 à 10 µm environ, de préférence de 2 µm, pour des couches en silicium initialement amorphe destinées respectivement aux dispositifs microélectroniques et aux cellules solaires. Le cristal 3 porte une couche 4 très fine. La couche 1 peut être en silicium amorphe, microcristallin ou polycristallin à grains fins, avec ou non des éléments abaissant la température de cristallisation (l'aluminium, l'or, le cuivre, l'argent ou le palladium, par exemple, pour le silicium), le cristal 3 est en silicium cristallin à gros grains ou monocristallin, et la couche 4 en une matière réfractaire comme le carbure de silicium, la silice, l'alumine ou encore le silicium poreux. Son épaisseur est de quelques nanomètres ou dixièmes de nanomètres. Les superficies en regard de la couche 1 et du cristal 3 peuvent être de plusieurs dizaines ou plusieurs centaines de centimètres carrés. Des cales 5 sont insérées entre les régions de bord de la couche 1 et du cristal 3 ; elles sont en une matière réfractaire et plutôt fines, ayant une épaisseur à titre d'exemple de quelques centaines de microns dans le cas de substrats 2 en verre (plus généralement 100 µm à 2 mm environ, de 1 à 2 mm environ dans le cas de substrats 2 en acier.

Si de l'acier est choisi, le type Invar (marque déposée) peut être préféré avec une couche de barrière au fer et aux autres éléments (titane, vanadium, zirconium) susceptibles de se diffuser dans le silicium en détruisant ses propriétés microélectroniques. Les faces en contact sont avantageusement polies pour améliorer le contact, ou décapées, par exemple à l'HF, pour les désoxyder et ne pas empêcher ainsi la cristallisation.

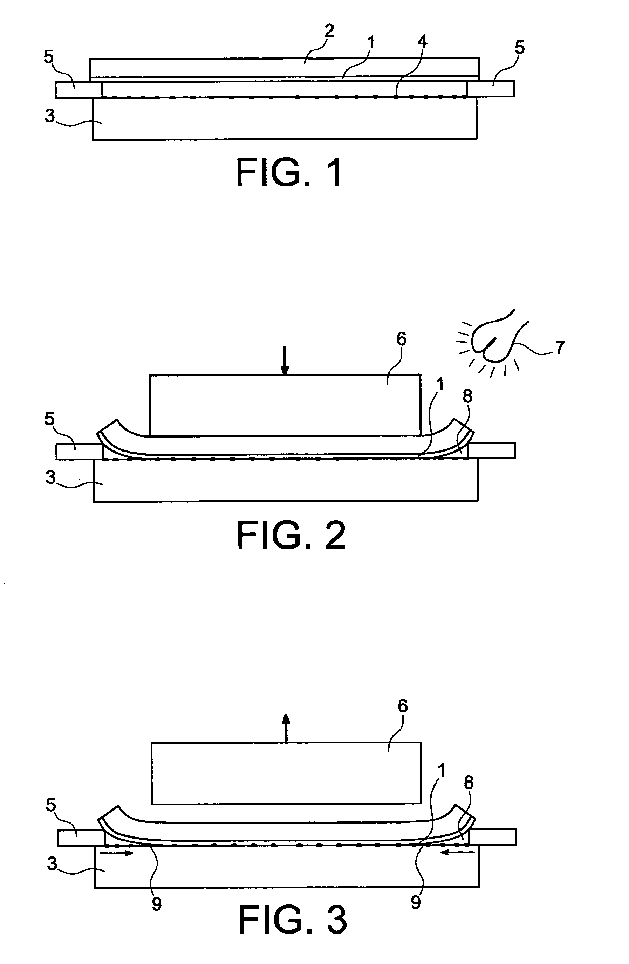

La figure 2 illustre l'application de la couche 1 sur le cristal 3 par une presse 6, pendant qu'un moyen de chauffage 7 élève la température de l'assemblage. La pression appliquée peut être de l'ordre de 500Pa à 5MPa environ, sans ici non plus que d'autres valeurs soient exclues, et la température peut être supérieure à 500°C. Une température élevée est préférable, mais le substrat 2 notamment la limite : le verre cesse d'être solide à 650°C environ, et les couches de barrière pour de l'acier cessent d'être efficaces à 800°C environ. On préférera donc une température proche de la température d'altération du substrat 2. En l'absence de telles limites concernant une température d'altération du substrat 2 quant à une propriété essentielle, on peut envisager de chauffer sous la température de fusion de la matière à cristalliser, soit 1300°C pour le silicium. Le cristal 3 impose sa structure à la couche 1 peu à peu à cette température, soit à travers les discontinuités de la couche 4, soit à travers les parties pleines de la couche 4 si elle est poreuse et en un matériau identique à celui de la couche 1. Le traitement thermique de recuit dure jusqu'à ce que la cristallisation de la couche 1 soit accomplie, selon un critère dont l'opérateur a décidé. Il est ainsi possible de décider qu'une cristallisation suffisante a été obtenue quand une indexation supérieure à 65% (60% à 70% plus généralement) a été obtenue dans une cartographie par diffraction d'électrons diffusés (propriété EBSD). Les régions périphériques 8, qui ne peuvent toucher le cristal 3 à cause des cales 5, font exception et correspondent à des zones mortes du procédé, mais leur largeur est faible, de quelques millimètres. Il est à noter que le chauffage peut commencer avant l'application de la pression pour les produits particulièrement fragiles.

Quand la pression est relâchée, on obtient l'état représenté à la figure 3, où une fissure 9 apparaît entre la couche 1 et le cristal 3 à partir des régions périphériques 8 et se propage vers le centre de l'assemblage jusqu'à provoquer un décollement complet. La fissure 9 peut apparaître aussi à l'interruption du chauffage sans la contribution d'une interruption de la pression d'application, en raison de cisaillements qui apparaissent aux frontières de la couche poreuse 4, dont le coefficient de dilatation est différent de celui de la couche 1 et produit donc des dilatations thermiques différentielles. Quand la couche 1 a été libérée, il est possible de rectifier sa surface par un polissage fin, pouvant être inférieur à 0,1µm. Des solutions à base de cires colloïdales (Chemical Mechanical Polishing, polissages mécano-chimiques) peuvent être employées. Les conditions pour faire apparaître la fissure sont remplies facilement si le substrat 2 a une élasticité suffisante pour produire le cisaillement nécessaire en se redressant. Le silicium et d'autres matières analogues sont d'ailleurs suffisamment fragiles pour autoriser la progression de la fissuration.

## Revendications

1. Procédé de cristallisation d'une couche (1), comprenant une application sur la couche (1) d'un cristal (3) formé de la matière de la couche et ayant une structure cristalline voulue pour la couche, et un traitement thermique de la couche afin d'y instaurer la structure du cristal, **caractérisé en ce que** l'application est produite par une pression mécanique sur la couche ou un substrat (2) de la couche (1), après avoir intercalé des cales (5) à des bords (8) de la couche entre la couche et le cristal, produisant ainsi une flexion de la couche.

2. Procédé de cristallisation suivant la revendication 1, **caractérisé en ce qu'**une couche de séparation (4), plus fine que les cales (5), est déposée entre la couche et le cristal dans une région entourée par les cales, la couche de séparation étant discontinue.

3. Procédé de cristallisation suivant la revendication 1 ou 2, **caractérisé en ce qu'**une couche de séparation, plus fine que les cales, est déposée entre la couche et le cristal dans une région entourée par les cales, la couche de séparation étant discontinue, la couche de séparation étant d'une matière différente de celle du cristal et de la couche.

4. Procédé de cristallisation d'une couche suivant l'une quelconque des revendications précédentes, **caractérisé en ce que** la pression mécanique est comprise entre 500Pa et 5MPa.

5. Procédé de cristallisation d'une couche suivant l'une quelconque des revendications précédentes, **caractérisé en ce que** les cales ont une épaisseur comprise entre 100µm et 2mm quand le substrat est en verre, entre 1mm et 2mm quand le substrat est en acier.

6. Procédé de cristallisation d'une couche suivant l'une quelconque des revendications précédentes, **caractérisé en ce que** le traitement thermique est un chauffage, mené à une température proche d'une température d'altération du substrat.

7. Procédé de cristallisation d'une couche suivant l'une quelconque des revendications précédentes, **caractérisé en ce que** le cristal (3) et/ou la couche (1) subissent un décapage de désoxydation avant l'application.

## Patentansprüche

1. Verfahren zur Kristallisation einer Schicht (1), umfassend das Aufbringen eines Kristalls (3) auf die Schicht (1), der gebildet ist aus dem Material der Schicht und eine kristalline Struktur aufweist, die für die Schicht gewünscht ist, und eine thermische Behandlung der Schicht, um dort die Kristallstruktur zu bilden, **dadurch gekennzeichnet, dass** die Aufbringung erfolgt durch einen mechanischen Druck auf die Schicht oder ein Substrat (2) der Schicht (1) nach Einlegen der Keile (5) an den Rändern (8) der Schicht zwischen der Schicht und dem Kristall, wodurch eine Biegung der Schicht erzeugt wird.

2. Kristallisationsverfahren nach Anspruch 1, **dadurch gekennzeichnet, dass** eine Trennschicht (4), die viel dünner ist als die Keile (5), angeordnet wird zwischen der Schicht und dem Kristall, in einem Bereich, der von den Keilen eingeschlossen ist, wobei die Trennschicht diskontinuierlich ist.

3. Kristallisationsverfahren nach Anspruch 1 oder 2, **dadurch gekennzeichnet, dass** eine Trennschicht , die viel dünner ist als die Keile, angeordnet ist zwischen der Schicht und dem Kristall, in einem Bereich, der von den Keilen eingeschlossen ist, wobei die Trennschicht diskontinuierlich ist, wobei die Trennschicht aus einem Material besteht, das verschieden von dem des Kristalls und der Schicht ist.

4. Kristallisationsverfahren für eine Schicht nach einem der vorhergehenden Ansprüche, **dadurch gekennzeichnet, dass** der mechanische Druck zwischen 500 Pa und 5 MPa umfasst.

5. Kristallisationsverfahren für eine Schicht nach einem der vorhergehenden Ansprüche, **dadurch gekennzeichnet, dass** die Keile eine Dicke aufweisen, umfassend zwischen 100 µm und 2 mm wenn das Substrat aus Glas ist und zwischen 1 mm und 2 mm wenn das Substrat aus Stahl ist.

6. Kristallisationsverfahren für eine Schicht nach einem der vorhergehenden Ansprüche, **dadurch gekennzeichnet, dass** die thermische Behandlung eine Erwärmung ist, die bei einer Temperatur erfolgt, die nahe der Veränderungstemperatur des Substrats ist.

7. Kristallisationsverfahren für eine Schicht nach einem der vorhergehenden Ansprüche, **dadurch gekennzeichnet, dass** der Kristall (3) und/oder die Schicht (1) einem Deoxidationsabtragen vor der Verwendung unterzogen wird.

## Claims

1. A method for crystallizing a layer (1), comprising applying on the layer (1) a crystal (3) formed from the material of the layer and having a crystal structure desired for the layer, and heat treating the layer in order to introduce the structure of the crystal therein, **characterised in that** the application is produced by mechanically pressing the layer or a substrate (2) of the layer (1), after wedges (5) have been fitted at edges (8) of the layer between the layer and the crystal, thereby producing a flexion of the layer.

2. The crystallizing method according to claim 1, **characterised in that** a separating layer (4), thinner than the wedges (5), is deposited between the layer and the crystal in a region surrounded by the wedges, the separating layer being discontinuous.

3. The crystallizing method according to claim 1 or 2, **characterised in that** a separating layer, thinner than the wedges, is deposited between the layer and the crystal in a region surrounded by the wedges, the separating layer being discontinuous, the separating layer being of a material different from that of the crystal and the layer.

4. The method for crystallizing a layer according to any of the preceding claims, **characterised in that** the mechanical pressure is between 500Pa and 5MPa.

5. The method for crystallizing a layer according to any of the preceding claims, **characterised in that** the wedges have a thickness between 100µm and 2mm when the substrate is made of glass, between 1mm and 2mm when the substrate is made of steel.

6. The method for crystallizing a layer according to any of the preceding claims, **characterised in that** the heat treatment is a heating, conducted at a temperature close to an alteration temperature of the substrate.

7. The method for crystallizing a layer according to any of the preceding claims, **characterised in that** the crystal (3) and/or the layer (1) undergo a deoxidation stripping before the application.
